Europäisches Patentamt

European Patent Office

Office européen des brevets

(11) Publication number: **0 187 716 B1**

# EUROPEAN PATENT SPECIFICATION

(45) Date of publication of patent specification: **13.03.91**

(51) Int. Cl.⁵: **H01S 3/25**, H01S 3/085, G11B 7/125

(21) Application number: **86300098.0**

(22) Date of filing: **08.01.86**

(54) Semiconductor laser array device.

(30) Priority: **09.01.85 JP 1658/85**

(43) Date of publication of application:
**16.07.86 Bulletin 86/29**

(45) Publication of the grant of the patent:
**13.03.91 Bulletin 91/11**

(84) Designated Contracting States:
**DE GB NL**

(56) References cited:
**EP-A- 0 038 085**
**GB-A- 1 407 351**
**JP-A-59 149 080**
**US-A- 4 092 659**
**US-A- 4 563 368**

(73) Proprietor: **NEC CORPORATION**
**7-1, Shiba 5-chome Minato-ku**
**Tokyo 108-01(JP)**

(72) Inventor: **Endo, Kenji c/o NEC Corporation**
**33-1 Shiba, 5-chome Minato-ku**
**Tokyo(JP)**

(74) Representative: **Pears, David Ashley et al**
**REDDIE & GROSE 16 Theobalds Road**
**London WC1X 8PL(GB)**

Rank Xerox (UK) Business Services

## Description

This invention relates to semiconductor laser array device.

A semiconductor laser device is suitable as a light source for a writable optical disc system, because of it's small size, light weight and small power consumption.

We have reported AℓGaAs BCM (Buried Coarctate Mesa-Structure) laser array suitable for use as the light source of a writable optical disc system in the 45th lecture meeting of the Japanese Institute of the Applied Physics, lecture No. 15a-R-7, published on Oct. 12, 1984. In this semiconductor laser array, two lasers are disposed in closely adjacent relation and in parallel with each other and driven independently with common opposite cleaved facets. One of the two lasers is used as a writing laser for writing an information, and the other laser of the two lasers is used as a reading laser for reading out the written information immediately after writing. When compared with a conventional optical disc system in which writing and reading are independently made by using a single semiconductor laser as a light source, the optical disc system described above has such advantages as the fast and accurate writing, the excellent reliability of writing and the short writing time. The writing laser is driven for producing a pulse output of high power of about 20 mW for writing informations on the optical disc. The reading laser is driven for producing a continuous output of low power of the order of 2 - 3 mW. The light output from the reading laser is applied to the optical disc and reflected from the same. The reading is performed by detecting the variation in the quantity of the reflected light. Accordingly, it is essential that the output of the reading laser is stable. When the driving current of the reading laser is constant, the output of the reading laser is caused to fluctuate by the ambient temperature change and by Joule heating due to the driving current of the writing laser. For this reason, it is necessary to compensate for the influence of the temperature variation by detecting the laser light output of the reading laser and changing the driving current. In the prior art semiconductor laser array device, however, it has been difficult to detect the monitoring output of the reading laser for the following reason. The reflectivity of the opposite surface of the cavity are the same in the writing laser and the reading laser. Consequently, the ratio of the output of the reading laser and the output of the writing laser during operation is about 1:10 on both surfaces of the cavity.

The lasing regions of the two lasers are disposed closely adjacent, and the spacing between the regions is set to be less than 100 microns due to the limit imposed by the effective field of view of the lens. On the other hand, the beam angle of the laser light is wide, that is larger than 10°. In view of these facts, in the prior art semiconductor laser array, for the purpose of detecting the output of the reading laser, the outputs of the two lasers are sampled on the front or rear surface of the cavity, then focused after magnifying with a lens and should be separated from the output of the writing laser by using a pin hole or the like. Accordingly, the construction of the optical system is complicated and a large labor and time are necessary for its assembling and adjusting.

## Summary of the Invention

According to this invention, there is provided a semiconductor laser array device comprising first and second closely adjacent semiconductor lasers formed from a plurality of semiconductor films and each including an active lasing layer, common front and rear cleaved facets perpendicular to the active layers, and electrode means for feeding driving current to each of the first and second lasers, characterised by first dielectric films formed over the entire front and rear surfaces of the device, a metal film having a high reflectivity formed on the rear first dielectric film to cover the cleaved facet of the active layer of the first laser, and a second dielectric layer formed on the entire rear surface of the device to enclose the metal film.

In a preferred embodiment of the invention it is possible to provide a novel semiconductor laser array device of a light weight, small size, small consumption of electric power and simple assembly and adjustment.

## Brief Description of the Drawings

In the accompanying drawing:
Fig.1 is a perspective view showing one embodiment of the semiconductor laser array device according to this invention; and
Fig. 2 is an upper side view of the embodiment shown in Fig. 1.

## Description of the Preferred Embodiment

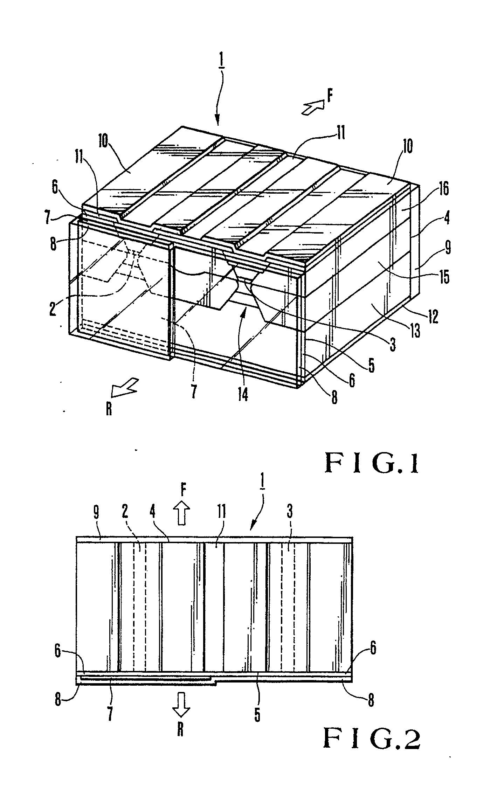

Figs. 1 and 2 show a semiconductor laser array device of this invention utilizing semiconductor laser of the BCM construction. The semiconductor laser array device 1 shown in Figs. 1 and 2 is constituted by two BCM lasers which constitute respective halves of the array and are driven independently. The sides of the semiconductor array device 1 designated by arrows F and R are termed the front side and the rear side, respectively. The front side means the emitting side of the laser light.

A BCM AℓGaAs laser constituting the main body of the semiconductor laser array 1 is prepared as follows. For simplifying the description, only the right half laser will be described. It should be understood that the left half is identical. At first, a plurality of AℓGaAs films having different compositions are sequentially grown by liquid phase epitaxial technique on an n type GaAs substrate. For example, an n-Aℓ$_y$Ga$_{1-y}$As layer (y = 0.38, 0.5 μm thick), an n-Aℓ$_x$Ga$_{1-x}$As guide layer (x = 0.3, 0.5 μm thick), an undoped Aℓ$_{0.11}$Ga$_{0.8a}$As active layer (0.05 - 0.08 μm thick), a p-Aℓ$_{0.5}$Ga$_{0.5}$As intermediate layer (0.3 μm thick), and a p-Aℓ$_{0.38}$Ga$_{0.62}$As cladding layer (1.5 μm thick) are sequentially grown starting from the side of substrate 13. Then the AℓGaAs multilayer is etched down to form a mesa structure by using a SiO$_2$ stripe as a mask. Then the sides of the intermediate layer and the active layer are etched to form a coarctate mesa 14 including a stripe shaped active layer 3 having a width of about 3 μm as shown in Fig. 1. After that, this coarctate mesa is buried in a p-Aℓ$_{0.38}$Ga$_{0.62}$As blocking layer 15 and a n-Aℓ$_{0.38}$Ga$_{0.62}$As burying layers 16. Finally, after diffusing Zn into the mesa top region, a substrate side electrode 12 and a mesa top side electrode 10 are secured. The left half BCM laser of the semiconductor laser array device 1 is prepared in the same manner. However, the top side electrode 10 of the BCM lasers on the right and left sides are separated by a SiO$_2$ film 11 at the center, so that the left and right BCM laser can be driven independently. SiO$_2$ protective films 9 and 6 are formed by sputtering method to cover entire surfaces of the front and rear surfaces 4 and 5, each film having a thickness of λ/2n (285 nm) where λ represents an oscillation wavelength of 830 nm, n the diffractive index of SiO$_2$.

Where the semiconductor laser array device 1 is used as the light source of an optical disc system, and if the left side laser having the active layer 2 is used for writing, while the right side laser having the active layer 3 is used for reading, an Au film 7 having a thickness of about 100 nm is formed on the SiO$_2$ film 6 of the rear surface of the writing laser to cover the cleaved facet of the active layer 2. This Au thin film is formed by vacuum vapor deposition method with a shielding plate having perforations in only a desired region, attached to the rear surface. As the thickness of the Au film increases, the percentage of light transmission decreases, thereby minimizing the effect of the laser light from the writing laser.

Finally, a SiO$_2$ protective film 8 having a thickness of 285 nm is formed on the entire surface of the rear surface of the semiconductor laser array device 1 by sputtering.

With the vacuum deposition method, thin film is formed only on the sample surface confronting the source of vapor deposition, whereas with the sputtering method, the film is formed on not only the surface confronting the source of sputtering but also the shadowed surface. Accordingly, the SiO$_2$ film 6 is formed to cover the entire surface including the electrodes 8 and 12. On the other hand, the Au film can be formed to cover only the cleaved facet of the active layer. Consequently, there is no fear that the Au film 7 contacts with the electrode 10 or 12 thereby causing short circuit. Furthermore, as the SiO$_2$ film 8 is formed to enclose the Au film 7, even when the semiconductor laser array device 1 is mounted on a heat sink or on a package with solder metal or the like, there is no fear of breakage caused by the reaction between the Au film and the solder metal.

The percentage of transmission of the laser light having an oscillation wavelength of 830 nm through an Au film of 100 nm thick is small, for example less than 0.1%. For this reason, even when the output from the front surface of the writing semiconductor laser amounts to 20 mW, the laser light observed at the rear side is faint. On the other hand, the output from the rear surface of the reading semiconductor laser is the same as the output from the front surface, that is 2 - 3 mW. A photodetector, not shown, is disposed to confront the rear surface of the semiconductor laser array device 1 and the ratio of the output of the photodetector to the output from the rear surface of the writing semiconductor laser was measured, and the result of measurement showed a large value of larger than 25 decibels, whereby it was possible to detect the laser output from the reading laser without any appreciable influence of the laser output from the writing laser.

As above described, the semiconductor laser array device embodying the invention enables to take out the monitoring light adapted to maintain the reading laser output at a constant value with a simple method of disposing a photodetector to confront the rear surface of the laser array device. This makes it unnecessary such optical elements as a monitor light isolating and condensing lens and a pin hole or the like which have been indispensable for the prior art semiconductor laser array arrangement, thus eliminating the labor of assembling these component parts. As a consequence, the manufacturing cost and the installation space of the optical disc system can be reduced greatly.

Although in the foregoing embodiment, the thickness of the SiO$_2$ films 6 and 8 were about λ/2n, when the thickness is made to be λ/4n, that is about 142.5 nm the reflection index of the front surface of the writing laser becomes about 8%, thus increasing the efficiency of the output while at the same time the maximum output can be increased to about twice. This results in the decrease of the driving current of the writing laser as well as the improvement of the reliability.

Although in the foregoing embodiment, $SiO_2$ was used to form a transparent dielectric film, $Al_2O_3$ or $Si_3N_4$ can be substituted for $SiO_2$ to produce the same advantageous effect. Furthermore, $Al$, $Cr$, $Ti$ and $Pt$ can be used to form the metal film 7.

An $AlGaAs$ laser array device having different oscillation wavelength can provide the same effect. Semiconductor laser array device made of such other semiconductor materials as $AlGaInP$ and $InGaAsP$ can also produce the same advantageous effect. Different from the element construction of the lasers constituting the laser array device, a semiconductor laser having a construction not of the buried type having a continuous active layer can also provide the same effect.

## Claims

1. A semiconductor laser array device comprising first and second closely adjacent semiconductor lasers formed from a plurality of semiconductor films and each including an active lasing layer (2, 3), common front and rear cleaved facets perpendicular to the active layers, and electrode means (10, 12) for feeding driving current to each of the first anti second lasers, characterised by first dielectric films (6 and 9) formed over the entire front and rear surfaces of the device, a metal film (7) having a high reflectivity formed on the rear first dielectric film (6) to cover the cleaved facet of the active layer (2) of the first laser, and a second dielectric layer (8) formed on the entire rear surface of the device to enclose the metal film (7).

2. A semiconductor laser array device according to claim 1, characterised in that the first and second dielectric films (6, 9, 8) are formed by sputtering and the metal film (7) is formed by a vacuum deposition method.

3. A semiconductor laser array device according to claim 1 or 2, characterised in that the lasers are buried coarctate mesa-structured $AlGaAs$ lasers.

## Revendications

1. Dispositif à réseau laser en semiconducteur comprenant des premier et second lasers en semi-conducteur étroitement contigus, formés d'une multitude de pellicules de semi-conducteur et chacune comportant une couche active à effet laser (2, 3), des facettes avant et arrière communes clivées perpendiculaires aux couches actives, et des moyens d'électrode (10, 12) pour appliquer un courant d'attaque à chacun des premier et second lasers, caractérisé par des premières pellicules en diélectrique (6 et 9) formées sur la totalité des surfaces avant et arrière du dispositif, une pellicule métallique (7) présentant une réflectivité élevée, formée sur la première pellicule arrière en diélectrique (6) pour recouvrir la facette clivée de la couche active (2) du premier laser, et une seconde couche en diélectrique (8) formée sur la totalité de la surface arrière du dispositif afin d'enfermer la pellicule métallique (7).

2. Dispositif à réseau laser en semi-conducteur selon la revendication 1, caractérisé en ce que les première et seconde pellicules en diélectrique (6, 9, 8) sont formées par pulvérisation, et la pellicule métallique (7) est formée par le procédé de déposition sous vide.

3. Dispositif à réseau laser en semi-conducteur selon la revendication 1 ou 2, caractérisé en ce que les lasers sont des lasers AlGaAs à structure mésa, coarctés, ensevelis.

## Ansprüche

1. Halbleiterlaser-Vielfachanordnung mit ersten und zweiten eng benachbarten Halbleiterlasern, die von mehreren dünnen Halbleiterschichten gebildet werden und jeweils eine aktive Laserschicht (2, 3), eine gemeinsame vordere und rückwärtige gespaltene Kristallfläche senkrecht zu den aktiven Schichten und Elektrodeneinrichtungen (10, 12) aufweisen zum Zuführen von Steuerströmen zu jedem der ersten und zweiten Laser, **gekennzeichnet durch** erste dielektrische Filme (6 und 9), die über die gesamte vordere und rückwärtige Fläche der Vorrichtung ausgebildet sind, einen Metallfilm (7) mit einer hohen Reflektivität, der auf dem rückwärtigen ersten dielektrischen Film (6) ausgebildet ist, so daß die gespaltene Kristallfläche der aktiven Schicht (2) des ersten Lasers abgedeckt ist und eine zweite dielektrische Schicht (8), die auf der gesamten rückwärtigen Fläche der Vorrichtung ausgebildet ist zum Einschließen des Metallfilms (7).

2. Halbleiterlaser-Vielfachanordnung nach Anspruch 1, **dadurch gekennzeichnet,** daß der erste und zweite dielektrische Film (6, 9, 8) durch Sputtern gebildet werden und der Metallfilm (7) durch ein Vakuumabscheidungsverfahren gebildet wird.

3. Halbleiterlaser-Vielfachanordnung nach Anspruch 1 oder 2, **dadurch gekennzeichnet,** daß die Laser vergrabene, eng zusammenliegende mesa-strukturierte AlGaAs-Laser sind.

FIG.1

FIG.2